(19) Europäisches Patentamt
European Patent Office
Office européen des brevets

(11) **EP 4 257 351 A1**

(12) **EUROPEAN PATENT APPLICATION**
published in accordance with Art. 153(4) EPC

(43) Date of publication:
**11.10.2023 Bulletin 2023/41**

(21) Application number: **21900465.2**

(22) Date of filing: **24.11.2021**

(51) International Patent Classification (IPC):
**B32B 9/00** (2006.01)    **B32B 27/36** (2006.01)
**C23C 14/08** (2006.01)

(52) Cooperative Patent Classification (CPC):
**B32B 9/00; B32B 27/36; C23C 14/08;** Y02W 30/80

(86) International application number:
**PCT/JP2021/043001**

(87) International publication number:
**WO 2022/118710 (09.06.2022 Gazette 2022/23)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **02.12.2020 JP 2020200501**

(71) Applicant: **TOYOBO CO., LTD.**
**Osaka-shi**
**Osaka 5300001 (JP)**

(72) Inventor: **ISEKI, Kiyoshi**
**Inuyama-shi, Aichi 484-8508 (JP)**

(74) Representative: **Vossius & Partner**
**Patentanwälte Rechtsanwälte mbB**
**Siebertstraße 3**
**81675 München (DE)**

(54) **TRANSPARENT GAS BARRIER FILM**

(57)    An object of the present invention is to provide an inexpensive transparent barrier film which uses a plastic film prepared using a recycled resin of PET bottles in consideration of the environment and has excellent acid resistance. A transparent gas barrier film includes an aluminum oxide layer mainly composed of aluminum oxide on at least one surface of a substrate polyester film. The absorption coefficient immediately after vapor-deposition of the aluminum oxide layer is less than 0.03 nm$^{-1}$. The vapor-deposition film thickness of the aluminum oxide layer is 6 nm or more and 10 nm or less. The substrate polyester film is a biaxially stretched polyester film containing 50% by weight or more of a polyester resin obtained by recycling PET bottles. A content of isophthalic acid, an intrinsic viscosity, a heat shrinkage rate, lamination strength, and thickness unevenness are within predetermined ranges.

Fig.3

**Description**

TECHNICAL FIELD

The present invention relates to a packaging material requiring hermeticity for a food product, a medical product, electronic parts and the like having excellent transparency, gas barrier properties, printing properties, flexibility and the like. More specifically, the present invention relates to a transparent barrier film having excellent characteristics as a gas blocking material, in which an aluminum oxide layer is laminated on a plastic film using a polyester resin obtained by recycling PET bottles.

BACKGROUND ART

In recent years, there have been increasing interests in environmental problems and garbage. There has been a demand for reducing the use of disposable plastic containers and the like. It has also been said that waste due to the best-before expiration of food is reduced.

For this reason, the reduction, reuse, and recycling of plastic products have been desired. Although various techniques are carried out, there is a technique of recycling PET bottles used in large amounts to reuse the PET bottles as packaging films.

A technique of a film is disclosed, in which a polyester resin obtained by recycling PET bottles is used to improve adhesion strength with other films while having good heating dimensional stability and a uniform thickness (see, for example, Patent Document 1).

A technique is known, in which a packaging material having gas barrier properties (low oxygen transmission amount and low water vapor transmission amount) is used for extending the best-before expiration date of food to prevent the deterioration of contents. As a soft packaging material, a technique of a transparent barrier film in which a metal oxide layer is laminated on a plastic film is known (see, for example, Patent Document 2).

As the metal oxide, silicon oxide and aluminum oxide and the like are often used from the viewpoint of transparency. The metal oxide layer is mainly laminated on a plastic film by a vapor-deposition method or a CVD method.

In particular, a laminated film that includes, as a barrier layer, an aluminum oxide layer formed by a reactive vapor-deposition method of evaporating aluminum and introducing oxygen is mainly used (see, for example, Patent Document 3).

Furthermore, there is a transparent barrier film in which a metal oxide layer is laminated using a recycled plastic film as a substrate (see, for example, Patent Document 4).

In the transparent barrier film having the aluminum oxide layer formed by the reactive vapor-deposition used in Patent Document 3, a vapor-deposition material is inexpensive aluminum, and the evaporation temperature of aluminum is also low, whereby the transparent barrier film can be formed by a relatively inexpensive apparatus having an induction heating type or resistance heating type vapor-deposition source. Therefore, the transparent barrier film having the aluminum oxide layer is provided as a packaging material at a lower cost than that of a transparent barrier film containing silicon oxide or silicon oxide and aluminum oxide as a vapor-deposition material. However, if acidic contents are put into a bag formed by using the transparent barrier film having the aluminum oxide layer, the barrier properties of the bag are deteriorated, which disadvantageously causes the deterioration in the contents to proceed.

Therefore, for coping, there is used a barrier layer composed of silicon oxide as an expensive vapor-deposition material, or a layer formed by an expensive vapor-deposition apparatus using an electron beam vapor-deposition source and obtained by mixing silicon oxide with aluminum oxide.

PRIOR ART DOCUMENT

PATENT DOCUMENTS

Patent Document 1: WO2014/050844
Patent Document 2: JP-B-2929609
Patent Document 3: JP-B-2638797
Patent Document 4: WO2015/146496

SUMMARY OF THE INVENTION

PROBLEMS TO BE SOLVED BY THE INVENTION

The present invention has been made in view of the problems of the conventional technique. That is, an object of the present invention is to provide an inexpensive transparent barrier film having excellent acid resistance in consideration of environmental problems.

MEANS FOR SOLVING THE PROBLEMS

As a result of intensive studies, the present inventors have found that the above problems can be solved by the following means, and have reached the present invention. That is, the present invention has the following configurations.

The present invention relates to a transparent gas barrier film comprising an aluminum oxide layer mainly composed of aluminum oxide on at least one surface of a substrate polyester film, wherein an absorption coefficient immediately after vapor-deposition of the aluminum oxide layer is less than 0.03 $nm^{-1}$, a vapor-deposition film thickness of the aluminum oxide layer is 6 nm or more and 10 nm or less, the substrate polyester film is a biaxially stretched polyester film containing 50% by weight or more of a polyester resin obtained by recycling PET bottles, and the following requirements are satisfied:

(1) a content rate of an isophthalic acid component relative to total dicarboxylic acid components in a total polyester resin constituting the substrate polyester film is 0.5 mol% or more and 5.0 mol% or less;
(2) an intrinsic viscosity of the resin constituting the substrate polyester film is 0.58 dl/g or more and 0.70 dl/g or less;
(3) the substrate polyester film has a heat shrinkage rate of 0.1% or more and 1.5% or less at 150°C in a machine direction and a transverse direction;
(4) when a polyolefin film is laminated on an opposite side of the surface of the substrate polyester film on which the aluminum oxide layer is laminated, lamination strength between the polyolefin film and the substrate polyester film is 4.0 N/15 mm or more and 20.0 N/15 mm or less; and
**(5) a thickness Tn (n=l to 200) (unit: $\mu$m) of a film** of 1 m in the machine direction and 1 m in the transverse direction is measured at every 5 mm and at 200 points; and thickness unevenness determined by the following formula when a maximum thickness at this time is Tmax, a minimum thickness is Tmin, and an average thickness is Tave is 16% or less in each of the machine direction and the transverse direction:

$$\texttt{Thickness unevenness = \{(Tmax - Tmin)/Tave\} × 100 (\%).}$$

The present invention also relates to the transparent gas barrier film, wherein the absorption coefficient immediately after vapor-deposition is 0.02 $nm^{-1}$ or more.
The present invention relates to the transparent gas barrier film, wherein the absorption coefficient is finally 0.002 $nm^{-1}$ or less.

EFFECT OF THE INVENTION

The present invention makes it possible to provide an inexpensive transparent gas barrier film that has excellent transparency in consideration of environmental problems, can retain barrier properties even when packaging acidic contents, and can store the contents for a long period of time.

BRIEF DESCRIPTION OF THE DRAWINGS

Fig. 1 shows transmittance wavelength characteristics of a substrate plastic film and a transparent gas barrier film measured by a spectrophotometer.
Fig. 2 shows transmittance wavelength characteristics of a substrate plastic film, a D65 light source, and a color-matching function of a CIE standard colorimetric observer.
Fig. 3 is a schematic vapor-deposition view.
Fig. 4 is a schematic vapor-deposition view.
Fig. 5 is a schematic view showing one aspect of the inside of an extruder in a film forming facility.

Fig. 6 is a schematic vapor-deposition apparatus view.

## MODE FOR CARRYING OUT THE INVENTION

Hereinafter, the present invention will be described in detail.

A transparent gas barrier film of the present invention includes a plastic film including an aluminum oxide layer provided on at least one surface of the plastic film, the aluminum oxide layer mainly composed of aluminum oxide. An absorption coefficient of the aluminum oxide layer immediately after vapor-deposition is less than 0.03 $nm^{-1}$, and a film thickness of the aluminum oxide layer is 6 nm or more and 10 nm or less.

The aluminum oxide layer mainly composed of aluminum oxide in the present invention substantially contains 99% or more of aluminum oxide and other components as impurities. The aluminum oxide contains not only a stoichiometrically complete oxide but also aluminum oxide that is deficient in oxygen.

When the total light transmittance of the aluminum oxide layer is Tal% and the film thickness of the aluminum **oxide layer is tal nm, the absorption coefficient** $\alpha$ **in the** present invention can be represented by Formula 1.

$$\alpha = -1/tal \cdot \ln(Tal/100) \; ... \; \text{Formula (1)}$$

When the total light transmittance of the transparent gas barrier film having the aluminum oxide layer is T0% and the total light transmittance of the substrate plastic film on which the aluminum oxide layer is laminated is Tb%, the total light transmittance Tal% of the aluminum oxide layer can be represented by Formula (2).

$$Tal = T0/Tb \times 100 \; ... \; \text{Formula (2)}$$

The film thickness of the aluminum oxide layer of the present invention is a value determined by a fluorescent X-ray apparatus with the density of the aluminum oxide thin film being 0.74 times (2.94 $g/cm^3$) a bulk density (3.97 $g/cm^3$). The reason why the density of the aluminum oxide thin film is 0.74 times the bulk density is that the film thickness is well matched with an actual film thickness obtained by TEM or the like.

In order to obtain the film thickness using the fluorescent X-ray apparatus, it is necessary to measure a sample having a known film thickness in advance using the fluorescent X-ray apparatus, obtain a fluorescent X-ray dose emitted from the sample, and create a calibration curve of the film thickness and fluorescent X-ray intensity.

In a sample used for creating a calibration curve of fluorescent X-rays, an aluminum adhesion amount per unit area is identified by inductively coupled plasma emission spectroscopy, and the aluminum adhesion amount is converted into a film thickness by the density of an aluminum oxide thin film, to measure the film thickness.

The total light transmittance in the present invention refers to a total light transmittance according to JIS K7375. In an optical film thickness meter installed to measure a film thickness in a vapor-deposition apparatus, a light source such as a fluorescent lamp, a xenon lamp, or a white LED is used to make light incident on one surface to be measured and measure an amount of light emitted from the other. The measured value is correlated to a total light transmittance of a sample measured in advance according to JIS K7375 with the optical film thickness meter, and treated as the total light transmittance.

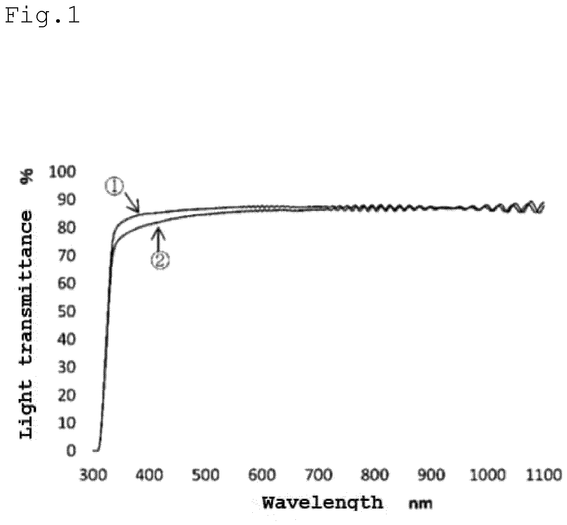

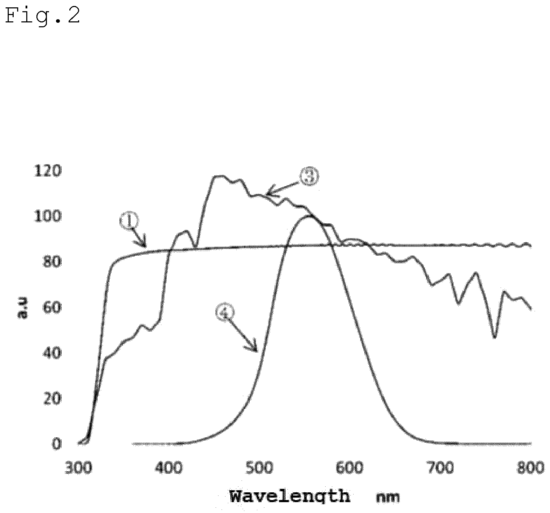

Fig. 1 shows a graph obtained by measuring light transmittances of a substrate plastic film and a transparent barrier film by a spectrophotometer. The light transmittance 2 of the transparent barrier film causes monotonous light absorption at any wavelength as compared with the light transmittance 1 of the substrate plastic film. A value obtained by converting the value of the optical film thickness meter can also be treated as the total light transmittance in consideration of a D65 light source as defined as a light source in JIS K7375 and the wavelength region of the color-matching function of a CIE standard colorimetric observer. Fig. 2 shows a wavelength region.

The transparent gas barrier film of the present invention includes a plastic film including an aluminum oxide layer provided on at least one surface of the plastic film, the aluminum oxide layer mainly composed of aluminum oxide. An absorption coefficient of the aluminum oxide layer immediately after vapor-deposition is less than 0.03 $nm^{-1}$.

A method for producing a transparent gas barrier film of the present invention is a method for producing a transparent gas barrier film including a plastic film including an aluminum oxide layer provided on at least one surface of the plastic film, the aluminum oxide layer mainly composed of aluminum oxide. The method includes an aluminum oxide layer forming step of adjusting an absorption coefficient of the aluminum oxide layer immediately after vapor-deposition to less than 0.03 $nm^{-1}$.

"Immediately after vapor-deposition" in the present invention refers to a time point when an optical thickness is measured for film thickness control or the like immediately after an aluminum oxide layer is vapor-deposited on a plastic film in a vacuum chamber.

If the vapor-deposited aluminum oxide layer comes into contact with oxygen, the oxidation of the aluminum oxide layer further proceeds, which causes change in the total light transmittance.

After the completion of the vapor-deposition, the plastic film after vapor-deposition is taken out from the vapor-deposition apparatus, and the total light transmission amount is immediately measured, which coincides with that at the time point when the optical thickness is measured.

Even if the transparent barrier film is exposed to the atmosphere to promote the oxidation of the transparent barrier film, and a bag is formed by using the transparent barrier film to package an acidic substance, the absorption coefficient immediately after vapor-deposition of 0.03 $nm^{-1}$ or more causes deteriorated barrier properties of the bag. That is, the barrier film has poor acid resistance. The absorption coefficient immediately after vapor-deposition is preferably less than 0.03 $nm^{-1}$.

The barrier film has a structure in which molecules of acids easily approach metal atoms. Alternatively, it is unclear whether metal oxide atoms are in a state of easily reacting with acids, but deterioration in the barrier film due to the acids occurs.

The acid resistance in the present invention means that an aluminum oxide layer as a barrier layer does not lose its barrier properties due to chemical change in the aluminum oxide layer caused by acids when highly acidic contents are put in a package including a transparent barrier film.

The absorption coefficient immediately after vapor-deposition is preferably 0.02 $nm^{-1}$ or more. In the method for producing a transparent gas barrier film of the present invention, the absorption coefficient immediately after vapor-deposition is preferably adjusted to 0.02 $nm^{-1}$ or more. If the absorption coefficient is less than 0.02 $nm^{-1}$, the degree of oxidation of aluminum oxide is high, which provides improved transparency, but a water vapor transmission rate is reduced, which is not preferable as the barrier film.

It is presumed that the aluminum oxide layer largely reacts with oxygen during vapor-deposition, which causes a decreased density of the aluminum oxide layer, but it is not clear.

"The absorption coefficient is finally 0.002 $nm^{-1}$ or less" in the present invention means that the absorption coefficient is 0.002 $nm^{-1}$ or less when the absorption coefficient is obtained after the transparent barrier film in which the aluminum oxide layer is laminated on the substrate plastic film by vapor-deposition is taken out from the vacuum chamber, and the transparent barrier film is stored at least at room temperature of 10°C to 40°C for 1 week or more in a state where the aluminum oxide layer is exposed to the atmosphere.

In the transparent gas barrier film of the present invention, the film thickness of the inorganic oxide vapor-deposited layer is 6 nm or more and 10 nm or less. The method for producing a transparent gas barrier film of the present invention includes an aluminum oxide layer forming step of adjusting the film thickness of the aluminum oxide layer to 6 nm or more and 10 nm or less. When the absorption coefficient finally exceeds 0.002 $nm^{-1}$, the light absorption of the thin film exceeds 1% even if the film thickness is 10 nm or less, which disadvantageously causes coloring. The coloring can also be suppressed by reducing the film thickness, but if the film thickness is 5 nm, the barrier properties become problematic.

As a method for producing a transparent barrier film having an aluminum oxide layer having a film thickness of 10 nm or less and an absorption coefficient immediately after vapor-deposition of 0.03 $nm^{-1}$ or less, a reactive vapor-deposition method is suitable.

The reactive vapor-deposition method is a method in which oxygen is introduced into a vapor-deposition tank where metal aluminum is evaporated by heating, to oxidize the metal aluminum, thereby depositing aluminum oxide on a substrate plastic film. As a method for evaporating metal aluminum by heating, a resistance heating method, an induction heating method, and an electron beam heating method can be used.

Examples of a method for controlling the film thickness include a method in which an aluminum oxide layer deposited on a plastic film is measured with a film thickness meter using fluorescent X-rays, and the heating is adjusted to control the film thickness in comparison with the target film thickness. In this case, in order to set the absorption coefficient to 0.03 $nm^{-1}$ or less, a photometer that irradiates light from one side of the plastic film and measures light transmitted from the other side is installed, to control the amount of oxygen introduced according to the amount of the total transmission light.

Alternatively, metal aluminum is first vapor-deposited on the substrate plastic film. The thickness of the deposited metal aluminum is controlled by an optical film thickness meter that irradiates light from one side of the plastic film after vapor-deposition and measures light transmitted from the other side to convert the measured value into a film thickness, thereby making the film thickness constant. Thereafter, oxygen is introduced to deposit aluminum oxide. At that time, there is used a production method in which an optical film thickness meter is used as a measurement meter of the total light transmittance under a constant evaporation condition to control the amount of oxygen introduced so as to achieve the target total light transmittance. The latter production method is preferable because the apparatus is simple.

In the method using the optical film thickness meter, a resistance heating method in which an aluminum wire as an evaporation source is supplied to a boat type heating element to evaporate the aluminum wire is suitable. After oxygen is introduced, the film thickness cannot be calculated from the total light transmittance. In the boat-type evaporation source, aluminum as an evaporation material is supplied in a wire form. Accordingly, it is found that if a wire supply speed when an evaporation amount reaches the target is maintained, if the evaporation is delayed, or if molten aluminum on the boat increases, the evaporation amount decreases. When the evaporation amount increases, the supply of the wire cannot catch up the increase, whereby the evaporation amount does not exceed a certain level. As described above, if the vapor-deposition rate of aluminum is once determined, the vapor-deposition rate is stabilized, which is preferable.

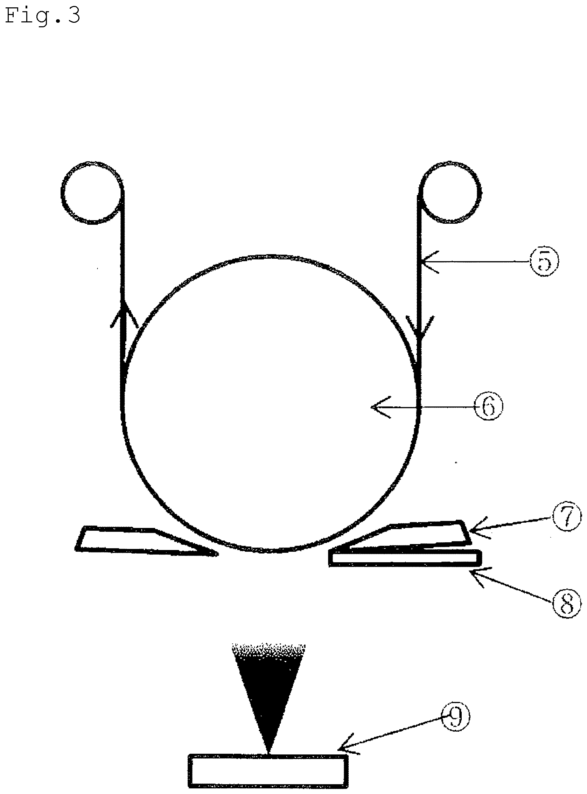

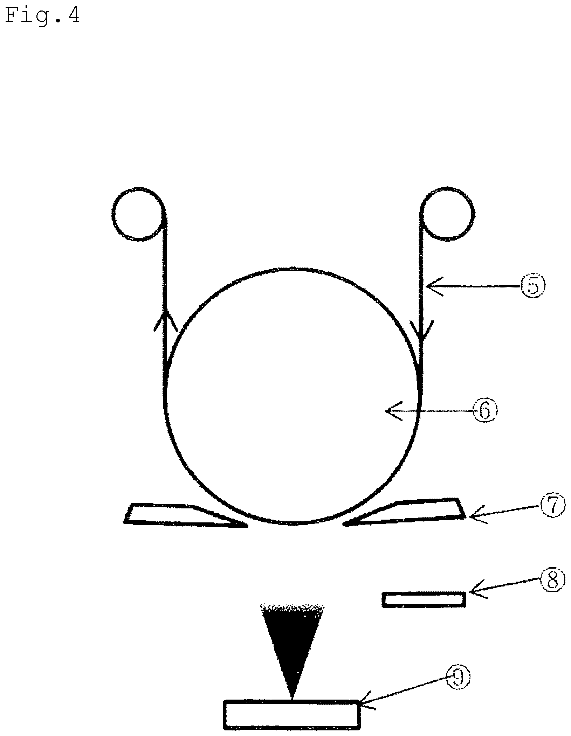

Figs. 3 and 4 show schematic views of the vapor-deposition apparatus. Aluminum evaporating from a vapor-deposition source (9) is deposited on a substrate plastic film (5) on a coating roll (6). A coating window (7) is installed near the coating roll (6) in order to limit the angle of incidence of aluminum vapor on the substrate or to prevent the adhesion of aluminum to unnecessary places.

As shown in Fig. 3, an oxygen inlet (8) is preferably installed close to the coating roll (6) so as not to hinder the flow of the aluminum vapor.

It is considered that if the oxygen inlet (8) is brought close to the evaporation source as shown in Fig. 4, aluminum is oxidized at the evaporation source, which causes an unstable evaporation rate. As shown in Fig. 4, if oxygen is introduced at a position away from the flow of the aluminum vapor, the probability that the oxygen encounters aluminum atoms decreases, whereby the oxygen is not effectively used. Unconsumed oxygen increases a pressure in a vacuum vapor-deposition tank. If vapor-deposition is performed in a situation where the pressure is high, the density of the formed film tends to decrease.

A decrease in the density of the aluminum oxide is estimated to cause reduced ability to hinder the permeation of a gas.

Therefore, a pressure for performing vapor-deposition is preferably $1 \times 10^{-2}$ Pa or less in consideration of the fact that the density of the aluminum oxide increases to provide improved barrier properties.

In Fig. 4, the oxygen inlet (8) can be placed in the aluminum vapor to increase the efficiency, but aluminum or aluminum oxide adheres to the oxygen inlet to cause reduced efficiency of the deposition thereof on the substrate plastic film. If the deposited material adhering to the oxygen inlet (8) peels, drops, and enters the evaporation source, the evaporation amount changes, which is not preferable.

In the production of a transparent barrier film, vapor-deposition is preferably performed by a roll-to-roll method. Because the plastic film after vapor-deposition is taken out in a roll form, the aluminum oxide layer is not exposed to the atmosphere. Therefore, it is necessary to rewind the rolled plastic film once in the atmosphere to entrain air between layers of the plastic film. As a rewinding condition, it is preferable to rewind the plastic film under a condition that an air layer of 0.4 um or more is entrained. If the plastic film is rewound under a high-temperature high-humidity atmosphere, the plastic film after vapor-deposition may be blocked due to dew formation, whereby it is preferable that the temperature is 40°C or lower, and the relative humidity is 70 RH% or less.

The amount of air entrained can be represented by Formula (3). When the thickness of the rewound plastic **film is t um; the length thereof is** 1 m; the diameter of a paper tube used is 2r mm; and the diameter of the wound **rolled plastic film is 2R mm, the thickness tair $\mu$m of the** layer of air entrained in the plastic film can be represented by Formula (3).

$$\texttt{tair = } \pi\texttt{(R}^2 \texttt{ - r}^2\texttt{)/1 - t ... Formula (3)}$$

The rewound rolled plastic film is preferably stored until the aluminum oxide layer is stabilized because the oxidation of the aluminum oxide layer gradually proceeds. A storage period needs to be at least 1 week at room temperature of 10°C to 40°C.

An increase in the temperature is presumed to promote the oxidation, but an increase in the temperature to 40°C or higher may affect the physical properties and the like of the film, which is not preferable. The temperature of 10°C or lower causes delayed oxidation, which is not preferable.

The transparent gas barrier film of the present invention preferably has, as gas barrier properties, an oxygen permeation amount of 1.0 ml/m$^2$/day (24 hr)/MPa or more and 100 ml/m$^2$/day (24 hr)/MPa or less in untreating and after evaluation of acid resistance described later in an atmosphere having a temperature of 23°C and a relative humidity of 65% RH. If the gas barrier properties exceed 100 ml/m$^2$/day/MPa, the use of the transparent gas barrier film for foods, pharmaceuticals, and industrial products and the like may become difficult, which is not so preferable. The gas barrier properties are preferably lower, but in the current technical level, the lower limit of the barrier properties in this configuration is 1.0 ml/m$^2$/day/MPa, and even the gas barrier properties of 1.0 ml/m$^2$/day/MPa are practically sufficient. The gas barrier properties are more preferably 1.0 ml/m$^2$/day/MPa or more and 70 ml/m$^2$/day/MPa or less, and particularly preferably 1.0 ml/m$^2$/day/MPa or more and 30 ml/m$^2$/day/MPa or less.

The plastic film in the present invention is a film obtained by melt-extruding a polyester resin obtained by recycling PET bottles and biaxially stretching the melt-extruded product by a biaxial stretching method. The biaxial stretching method is not particularly limited, and a tubular method or a simultaneous biaxial stretching method or the like can be employed. In particular, a sequential biaxial stretching method is preferable.

The lower limit of the intrinsic viscosity of the resin constituting the plastic film obtained by measuring the plastic film is preferably 0.58 dl/g, and more preferably 0.60 dl/g. If the intrinsic viscosity is less than 0.58 dl/g, the intrinsic viscosity of the recycled resin derived from PET bottles often exceeds 0.68 dl/g. If the viscosity of the recycled resin is reduced when a film is produced using the recycled resin, the thickness unevenness of the film may be poor, which is not preferable. The plastic film may be colored, which is not preferable. The upper limit of the intrinsic viscosity is preferably 0.70 dl/g, and more preferably 0.68 dl/g. If the intrinsic viscosity exceeds 0.70 dl/g, the resin is less likely to be discharged from an extruder to cause deteriorated productivity in some cases, which is not so preferable.

The lower limit of the thickness of the plastic film **is preferably 8 $\mu$m, more preferably 10 um, and still more preferably 12 $\mu$m. If the thickness is less than 8 $\mu$m, the** strength of the plastic film may be insufficient, which is not preferable. The upper limit of the thickness is **preferably 200 $\mu$m, more preferably 50 $\mu$m, and still more preferably 30 $\mu$m. If the thickness exceeds 200 $\mu$m, the** film becomes too thick, which may cause difficult processing.

The lower limit of the heat shrinkage rate of the plastic film in a machine direction (sometimes described as MD) and a transverse direction (sometimes described as TD) by treatment at 150°C for 30 minutes is preferably 0.1%, and more preferably 0.3%. If the heat shrinkage rate is less than 0.1%, the improvement effect may be saturated, and the film may become mechanically brittle, which is not preferable. The upper limit of the heat shrinkage rate is preferably 1.5%, and more preferably 1.2%. If the heat shrinkage rate exceeds 1.5%, pitch deviation and the like may occur due to dimensional change during processing such as printing, which is not preferable. If the heat shrinkage rate exceeds 1.5%, shrinkage in a transverse direction, and the like may occur due to dimensional change during processing such as printing, which is not preferable.

The lower limit of the refractive index of the plastic film in the thickness direction is preferably 1.4930, and more preferably 1.4940. If the refractive index is less than 1.4930, orientation is not sufficient, and therefore lamination strength may not be obtained. The upper limit of the refractive index is preferably 1.4995, and more preferably 1.4980. If the refractive index exceeds 1.4995, the orientation of the plane may collapse and the mechanical characteristics may be insufficient, which is not preferable.

The thickness unevenness determined by the following formula (4) when the thickness Tn (n=l to 20**0) (unit: $\mu$m)** of a plastic film of 1 m in the machine direction and 1 m in the transverse direction is measured at every 5 mm and at 200 points, the maximum thickness at this time is Tmax, the minimum thickness is Tmin, and the average thickness is Tave is preferably 16% or less, more preferably 12% or less, and still more preferably 10% or less in each of the machine and transverse directions. If the thickness unevenness exceeds 16%, winding deviation may occur when the film is formed into a plastic film roll, or the appearance defect of a peeled surface may occur when a laminated portion is peeled off, to cause a lowered commercial value, which is not so preferable.

$$\text{Thickness unevenness} = \{(Tmax - Tmin)/Tave\} \times 100 \ (\%) \ \dots$$

$$\text{Formula (4)}$$

The lower limit of the lamination strength when a polyolefin film is laminated on the opposite side surface of the aluminum oxide layer surface of the plastic film is preferably 4.0 N/15 mm, more preferably 4.5 N/15 mm, and still more preferably 5.0 N/15 mm. If the lamination strength is less than 4.0 N/15 mm, the laminated portion may be easily peeled off in the case of forming a bag, which is not preferable. The upper limit of the lamination strength is preferably 20.0 N/15 mm, more preferably 15.0 N/15 mm, and still more preferably 10.0 N/15 mm. If the lamination strength exceeds 20.0 N/15 mm, the plastic film may be substantially broken at the time of peeling off, which is not so preferable.

The appearance after lamination is evaluated by visually observing a sample after lamination peeling. It is preferable to dye an adhesive in order to make it easy to visually observe the sample. The evaluation is as follows. The good level means that there are no micro voids of the adhesive in the surface after peeling; the average level means that there are micro voids in 10% or less of the total peeled surface area; and the poor level means that there are micro voids in more than 10% of the total peeled surface area. The average level is preferable, and the good level is preferable. In the poor level, the product value is lowered due to poor appearance after the laminated portion is peeled off, which is not preferable. When the lamination strength is less than 4.0 N/15 mm, the basic characteristics in the present invention are not satisfied, and therefore even if the lamination strength is at the good level, the plastic film is not preferable.

A recycled polyester resin derived from PET bottles containing an isophthalic acid component as an acid component is preferably used as a raw material for the plastic film. The crystallinity of a polyester used for PET bottles is controlled in order to improve the appearance of a bottle, and as a result, a polyester containing 10 mol% or less of an isophthalic acid component may be used. In order to utilize the recycled resin, a material containing an isophthalic acid component may be used.

The lower limit of the amount of the terephthalic acid component in the total dicarboxylic acid components constituting the polyester resin contained in the plastic film is preferably 95.0 mol%, more preferably 96.0 mol%, still more preferably 96.5 mol%, and particularly preferably 97.0 mol%. If the amount is less than 95.0 mol%, crystallinity is deteriorated, whereby the heat shrinkage rate may increase, which is not so preferable. The upper limit of the amount of the terephthalic acid component in the polyester resin contained in the plastic film is preferably 99.5 mol%, and more preferably 99.0 mol%. Many of the recycled polyester resins derived from PET bottles contain dicarboxylic acid components typified by isophthalic acid besides terephthalic acid, whereby the amount of the terephthalic acid component constituting the polyester resin in the plastic film and exceeding 99.5 mol% consequently makes it difficult to produce a polyester film containing a recycled resin at a high rate, which is not so preferable.

The lower limit of the amount of the isophthalic acid component in the total dicarboxylic acid components constituting the polyester resin contained in the plastic film is preferably 0.5 mol%, more preferably 0.7 mol%, still more preferably 0.9 mol%, and particularly preferably 1.0 mol%. Recycled polyester resins derived from PET bottles contain a large amount of an isophthalic acid component, whereby the amount of the isophthalic acid component constituting the polyester resin in the film of less than 0.5 mol% consequently makes it difficult to produce a polyester film containing a recycled resin at a high rate, which is not so preferable. The upper limit of the amount of the isophthalic acid component in the total dicarboxylic acid components constituting the polyester resin contained in the plastic film is preferably 5.0 mol%, more preferably 4.0 mol%, still more preferably 3.5 mol%, and particularly preferably 3.0 mol%. If the amount exceeds 5.0 mol%, crystallinity is deteriorated, whereby the heat shrinkage rate may increase, which is not so preferable. When the content rate of the isophthalic acid component is within the above range, a plastic film having excellent lamination strength, an excellent shrinkage rate, and reduced thickness unevenness can be easily produced, which is preferable.

The upper limit of the intrinsic viscosity of the recycled resin derived from PET bottles is preferably 0.90 dl/g, more preferably 0.80 dl/g, still more preferably 0.77 dl/g, and particularly preferably 0.75 dl/g. If the intrinsic viscosity exceeds 0.90 dl/g, the resin is less likely to be discharged from an extruder, whereby the productivity may be lowered, which is not so preferable.

The lower limit of the content rate of the polyester resin obtained by recycling PET bottles in the plastic film is preferably 50% by weight, more preferably 65% by weight, and still more preferably 75% by weight. If the content rate is less than 50% by weight, the content rate is low for utilization of the recycled resin, which is not so preferable in terms of contribution to environmental protection. The upper limit of the content rate of the polyester resin obtained by recycling PET bottles is preferably 95% by weight, more preferably 90% by weight, and still more preferably 85% by weight. If the content rate exceeds 95% by weight, it is sometimes impossible to sufficiently add a lubricant or an additive such as inorganic particles for improving the function as a plastic film, which is not so preferable. A polyester resin obtained by recycling PET bottles may be used as a master batch (a resin contained in a high concentration) used when a lubricant or an additive such as inorganic particles is added for improving the function as a plastic film.

As the kind of the lubricant, inorganic lubricants such as silica, calcium carbonate, and alumina, and also organic lubricants are preferable, and silica and calcium carbonate are more preferable. By these lubricants, transparency and slipperiness can be exhibited.

The lower limit of the lubricant content rate in the plastic film is preferably 0.01% by weight, more preferably 0.015% by weight, and still more preferably 0.02% by weight. If the content rate is less than 0.01% by weight, the slipperiness may be deteriorated. The upper limit of the lubricant content rate is preferably 1% by weight, more preferably 0.2% by weight, and still more preferably 0.1% by weight. If the lubricant content rate exceeds 1% by weight, transparency may be deteriorated, which is not so preferable.

A method for producing the plastic film used in the laminated film of the present invention is not particularly limited, but for example, the following production method is recommended. It is important to set a temperature for melting and extruding a resin in an extruder. The basic idea is that (1) deterioration is suppressed by extrusion at a temperature as low as possible, since a polyester resin used for PET bottles contains an isophthalic acid component, and (2) the polyester resin has a portion that melts at a high temperature or a high pressure or the like in order to sufficiently and uniformly melt an intrinsic viscosity or a fine highly crystalline portion. Addition of the isophthalic acid component leads to deterioration in the tacticity of a polyester and a decrease in the melting point. Therefore, extrusion at a high temperature results in a significant decrease in melt viscosity or deterioration by heat, and also in a decrease in the mechanical strength and an increase in foreign matters resulting from the deterioration. Sufficient melt-kneading is impossible merely by lowering the extrusion temperature, which may result in problems of an increase in thickness unevenness and foreign matters such as fish eyes. From the above, examples of a recommended production method include a method of using two extruders in tandem, a method of increasing the pressure in a filter part, or a method of using a screw having a high shear force for a part of a screw constitution. Hereinafter, an example of controlling the temperature using one extruder will be described.

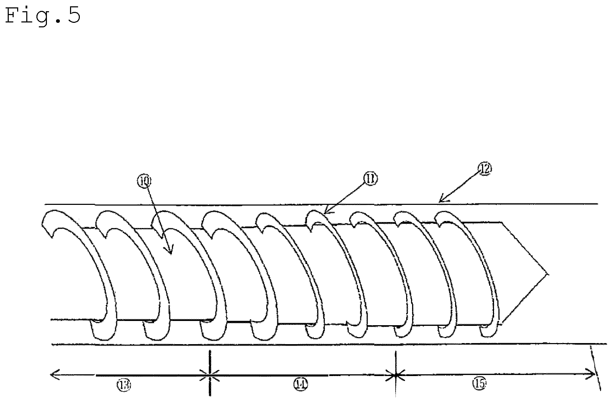

Fig. 5 shows one aspect of the inside of an extruder in a film forming facility in the present invention. A screw 10 having a flight 11 between barrels 12 includes a supply part 13, a compaction part 14, and a measurement part 15 from the base to the tip end thereof. The compaction part 14 is a region where the distance between the screw 10 and the barrels 12 is gradually narrowed. In the present invention, the extruder is preferably contrived to sufficiently carry out melt-kneading in the compaction part 14 in which the shear force is high, and to avoid thermal deterioration in the supply part 13 and the measurement part 15, by setting the temperature in the supply part 13 and the measurement part 15 as low as possible and setting the temperature in the compaction part 14 high.

The lower limit of the set temperature of the resin melting part in the extruder (excluding the highest set temperature of the compression part of the screw in the extruder) is preferably 270°C, and the upper limit thereof is preferably 290°C. If the set temperature is lower than 270°C, extrusion is difficult, and if the temperature exceeds 290°C, the resin may be deteriorated, which is not so preferable.

The lower limit of the highest set temperature in the compression part of the screw in the extruder is preferably 295°C. In a polyester resin used for PET bottles, crystals having a high melting point (260°C to 290°C) often exist in terms of transparency. An additive and a crystallization nucleating agent and the like are added, and unevenness in the fine melting behavior is observed in the resin material. If the highest set temperature is lower than 295°C, it is difficult to sufficiently melt them, which is not so preferable. The upper limit of the highest set temperature in the compression part of the screw in the extruder is preferably 310°C. If the highest set temperature exceeds 310°C, the resin may be deteriorated, which is not so preferable.

The lower limit of the time for the resin to pass the region at the highest set temperature in the compression part of the screw in the extruder is preferably 10 seconds, and more preferably 15 seconds. If the time is shorter than 10 seconds, the polyester resin used for PET bottles cannot be sufficiently melted, which is not so preferable. The upper limit of the time is preferably 60 seconds, and more preferably 50 seconds. If the time exceeds 60 seconds, the resin is apt to be deteriorated, which is not so preferable. By setting the extruder in such ranges, a film reduced in thickness unevenness, foreign matters such as fish eyes, and coloration can be obtained even if a large amount of a polyester resin obtained by recycling PET bottles is used.

The resin melted in this manner is extruded in a sheet-like form on a cooling roll, and then biaxially stretched. The stretching method may be a simultaneous biaxial stretching method, but a sequential biaxial stretching method is particularly preferable. These make it easy to satisfy productivity and quality required in the present invention.

A method for stretching the film in the present invention is not particularly limited, but the following points are important. In order to stretch a resin having an intrinsic viscosity of 0.64 dl/g or more and containing an isophthalic acid component, ratios and temperatures in the machine direction (MD) stretching and transverse direction (TD) stretching are important. If the MD stretch ratio and the temperature are not appropriate, a stretching force is not uniformly applied, and the orientation of molecules is insufficient, which may result in an increase in thickness unevenness or insufficient mechanical characteristics. The film may be broken in the next TD stretching step, or thickness unevenness may be extremely increased. If the TD stretch ratio and the temperature are not appropriate, the film may not be uniformly stretched; the balance of the machine and transverse orientations may be deteriorated; and the mechanical characteristics may be insufficient. When the next heat setting step is performed in the state that the thickness unevenness is significant or the molecular chain orientation is insufficient, relaxation cannot be uniformly performed, which causes problems of more significant thickness unevenness and insufficient mechanical characteristics. Therefore, it is basically recommended that in the MD stretching, stretching is performed step by step by performing temperature adjustment described below, and in the TD stretching, stretching is performed at an appropriate temperature so that the orientation balance is not extremely deteriorated. The present invention is not limited to the following aspects, but will be described with an example.

A machine direction (MD) stretching method is preferably a roll stretching method or an IR heating method.

The lower limit of the MD stretching temperature is preferably 100°C, more preferably 110°C, and still more preferably 120°C. Even if the MD stretching temperature is lower than 100°C, and a polyester resin having an intrinsic viscosity of 0.64 dl/g or more is stretched to orient molecules in the machine direction, the plastic film is broken in the next transverse stretching step or an extreme thickness defect is caused, which is not preferable. The upper limit of the MD stretching temperature is preferably 140°C, more preferably 135°C, and still more preferably 130°C. If the MD stretching temperature exceeds 140°C, the orientation of molecular chains becomes insufficient, whereby mechanical characteristics may become insufficient, which is not so preferable.

The lower limit of the MD stretch ratio is preferably 2.5 times, more preferably 3.5 times, and still more preferably 4 times. Even if the MD stretch ratio is less than 2.5 times, and a polyester resin having an intrinsic viscosity of 0.64 dl/g or more is stretched to orient molecules in the machine direction, the film may be broken in the next transverse stretching step or an extreme thickness defect may be caused, which is not so preferable. The upper limit of the MD stretch ratio is preferably 5 times, more preferably 4.8 times, and still more preferably 4.5 times. If the MD stretch ratio exceeds 5 times, the effect of improving mechanical strength and thickness unevenness may be saturated, which is not so meaningful.

The MD stretching method may be the above-mentioned one-stage stretching, but the film is preferably stretched in two or more stages. Stretching in two or more stages makes it possible to well stretch a polyester resin having a high intrinsic viscosity and derived from a recycled resin containing isophthalic acid, which provides reduced thickness unevenness, and improved lamination strength and mechanical characteristics.

The lower limit of the MD stretching temperature in the first stage is preferably 110°C, and more preferably 115°C. If the MD stretching temperature is lower than 110°C, heat is insufficient, whereby stretching in the machine direction cannot be sufficiently performed, resulting in poor flatness, which is not preferable. The upper limit of the MD stretching temperature in the first stage is preferably 125°C, and more preferably 120°C. If the MD stretching temperature exceeds 125°C, the orientation of molecular chains may become insufficient and mechanical characteristics may be deteriorated, which is not so preferable.

The lower limit of the MD stretch ratio in the first stage is preferably 1.1 times, and more preferably 1.3 times. If the MD stretch ratio is 1.1 times or more, finally, a polyester resin having an intrinsic viscosity of 0.64 dl/g or more can be sufficiently stretched in the machine direction by weak stretching in the first stage, and accordingly, the productivity can be improved. The upper limit of the MD stretch ratio in the first stage is preferably 2 times, and more preferably 1.6 times. If the MD stretch ratio exceeds 2 times, the orientation of molecular chains in the machine direction is too high, whereby the stretching may become difficult in the second stage or thereafter and the film may have significant thickness unevenness, which is not so preferable.

The lower limit of the MD stretching temperature in the second stage (or final stage) is preferably 10°C, and more preferably 115°C. If the MD stretching temperature is 110°C or higher, a polyester resin having an intrinsic viscosity of 0.64 dl/g or more can be sufficiently stretched in the machine direction and can be stretched in the transverse direction in the next step, so that the thickness unevenness in the machine and transverse directions can be reduced. The upper limit of the MD stretching temperature is preferably 130°C, and more preferably 125°C. If the MD stretching temperature exceeds 130°C, crystallization is promoted, whereby the transverse stretching may become difficult or the thickness unevenness may become significant, which is not so preferable.

The lower limit of the MD stretch ratio in the second stage (or final stage) is preferably 2.1 times, and more preferably 2.5 times. Even if the MD stretch ratio is less than 2.1 times, and a polyester resin having an intrinsic viscosity of 0.64 dl/g or more is stretched to orient molecules in the machine direction, the plastic film may be broken in the next transverse stretching step or an extreme thickness defect may be caused, which is not so preferable. The upper limit of the MD stretch ratio is preferably 3.5 times, and more preferably 3.1 times. If the MD stretch ratio exceeds 3.5 times, the orientation in the machine direction is too high, whereby the stretching may be impossible in the second stage or thereafter and the plastic film may have significant thickness unevenness, which is not so preferable.

The lower limit of the TD stretching temperature is preferably 110°C, more preferably 120°C, and still more preferably 125°C. If the TD stretching temperature is lower than 110°C, the stretching stress in the transverse direction is increased, whereby the plastic film may be broken or the thickness unevenness may become extremely significant, which is not so preferable. The upper limit of the TD stretching temperature is preferably 150°C, more preferably 145°C, and still more preferably 140°C. If the TD stretching temperature exceeds 150°C, the orientation of molecular chains does not increase, whereby mechanical characteristics may be deteriorated, which is not so preferable.

The lower limit of the transverse direction (TD) stretch ratio is preferably 3.5 times, and more preferably 3.9 times. If the stretch ratio is less than 3.5 times, molecular orientation is weak, whereby mechanical strength may become insufficient, which is not so preferable. The orientation of molecular chains in the machine direction is significant and the balance between the machine and transverse directions is deteriorated to make the thickness unevenness significant, which is not so preferable. The upper limit of the TD stretch ratio is preferably 5.5 times, and more preferably 4.5 times. If the TD stretch ratio exceeds 5.5 times, the film may be broken, which is not so preferable.

In order to obtain the plastic film used for the transparent gas barrier film of the present invention, it is desirable to appropriately set conditions for heat setting continuously performed in a tenter after the completion of the TD stretching and for the subsequent cooling of the plastic film to room temperature. As compared with a common polyethylene terephthalate film containing no isophthalic acid, a polyester film containing a recycled resin derived from PET bottles and containing isophthalic acid has low crystallinity, is apt to be melted in an ultra-fine level, and has poor mechanical strength. Therefore, when the polyester film is abruptly exposed to high temperatures under strain after completion of stretching, or when the polyester film is abruptly cooled under strain after completion of heat setting at high temperatures, a tensile force balance in the transverse direction is disordered due to an inevitable temperature difference in a film transverse direction, which results in thickness unevenness and defective mechanical characteristics. Meanwhile, if the heat setting temperature is lowered to deal with the phenomenon, sufficient lamination strength may not be obtained. In the present invention, it is recommended to perform steps of heat setting 1 at a slightly low temperature, heat setting 2 (as necessary, heat setting 3) at a sufficiently high temperature, and thereafter, gradual cooling to lower the temperature to room temperature after the completion of stretching. However, the present invention is not limited to this method, and other recommended methods include a method of controlling the film tension correspondingly to the velocity of hot air and the temperatures in the respective zones in the tenter; a method of performing heat treatment at a relatively low temperature in a furnace with a sufficient length after the completion of stretching; and a method of relaxing the film by heat rolls after the completion of the heat setting.

As one example, a method by controlling the tenter temperature will be described.

The lower limit of the temperature in the heat setting 1 is preferably 160°C, and more preferably 170°C. If the temperature is lower than 160°C, the heat shrinkage rate finally increases, and deviation and shrinkage may be caused at the time of processing, which is not so preferable. The upper limit of the temperature is preferably 215°C, and more preferably 210°C. If the temperature exceeds 215°C, the plastic film is abruptly exposed to a high temperature, whereby the thickness unevenness may become significant or the plastic film may be broken, which is not so preferable.

The lower limit of the time for the heat setting 1 is preferably 0.5 seconds, and more preferably 2 seconds. If the time is shorter than 0.5 seconds, the plastic film temperature increase may be insufficient. The upper limit of the time is preferably 10 seconds, and more preferably 8 seconds. If the time exceeds 10 seconds, productivity may be deteriorated, which is not so preferable.

The lower limit of the temperature in the heat setting 2 is preferably 220°C, and more preferably 227°C. If the temperature is lower than 220°C, the heat shrinkage rate may become significant, whereby deviation and shrinkage may be caused at the time of processing, which is not so preferable. The upper limit of the temperature is preferably 240°C, and more preferably 237°C. If the temperature exceeds 240°C, the film may be melted, or even if not melted, the film may be fragile, which is not so preferable.

The lower limit of the time for the heat setting 2 is preferably 0.5 seconds, and more preferably 3 seconds. If the time is shorter than 0.5 seconds, the film may be apt to be broken at the time of heat setting, which is not so preferable. The upper limit of the time is preferably 10 seconds, and more preferably 8 seconds. If the time exceeds 10 seconds, sagging or the like may occur to result in thickness unevenness, which is not so preferable.

The lower limit of the temperature in the case where the heat setting 3 is performed as necessary is preferably 205°C, and more preferably 220°C. If the temperature is lower than 205°C, the heat shrinkage rate may become significant, whereby deviation and shrinkage may be caused at the time of processing, which is not so preferable. The upper limit of the temperature is preferably 240°C, and more preferably 237°C. If the temperature exceeds 240°C, the film may be melted, or even if not melted, the film may be fragile, which is not so preferable.

The lower limit of the time in the case where the heat setting 3 is performed as necessary is preferably 0.5 seconds, and more preferably 3 seconds. If the time is shorter than 0.5 seconds, the film may be apt to be broken at the time of heat setting, which is not so preferable. The upper limit of the time is preferably 10 seconds, and more preferably 8 seconds. If the time exceeds 10 seconds, sagging or the like may occur to cause thickness unevenness, which is not so preferable.

TD relaxation may be carried out at any point in the heat setting. The lower limit thereof is preferably 0.5%, and more preferably 3%. If the TD relaxation is less than 0.5%, the heat shrinkage rate particularly in the transverse direction becomes significant, whereby deviation and shrinkage may be caused at the time of processing, which is not so preferable. The upper limit thereof is preferably 10%, and more preferably 8%. If the TD relaxation exceeds 10%, sagging or the like may occur to cause thickness unevenness, which is not so preferable.

The lower limit of the gradual cooling temperature after the TD heat setting is preferably 90°C, and more preferably 100°C. If the gradual cooling temperature is lower than 90°C, the plastic film contains isophthalic acid, whereby the thickness unevenness may become significant because of shrinkage by abrupt temperature change or the plastic film may be broken, which is not so preferable. The upper limit of the gradual cooling temperature is preferably 150°C, and more preferably 140°C. If the gradual cooling temperature exceeds 150°C, a sufficient cooling effect may not be obtained, which is not so preferable.

The lower limit of the gradual cooling time after the heat setting is preferably 2 seconds, and more preferably 4 seconds. If the gradual cooling time is shorter than 2 seconds, a sufficient gradual cooling effect may not be obtained, which is not so preferable. The upper limit thereof is preferably 20 seconds, and more preferably 15 seconds. The gradual cooling time exceeding 20 seconds is apt to be disadvantageous in terms of productivity, which is not so preferable.

In the transparent barrier film of the present invention, various layers that a known gas barrier film has may be provided as necessary besides the plastic film and the aluminum oxide layer.

For example, when a transparent barrier film having an inorganic thin film layer is used as a packaging material, it is preferable to form a heat-sealable resin layer called a sealant. The heat-sealable resin layer is usually provided on the inorganic thin film layer, but may be provided on the outside of the plastic film (a surface opposite to the inorganic thin film layer-formed surface thereof). The heat-sealable resin layer is usually formed by an extrusion lamination method or a dry lamination method. As a thermoplastic polymer that forms the heat-sealable resin layer, any one may be used as long as the adhesive properties of the sealant can be sufficiently exerted. Polyethylene resins such as HDPE, LDPE and LLDPE, a polypropylene resin, an ethylene-vinyl acetate copolymer, an ethylene-$\alpha$-olefin random copolymer, and an ionomer resin and the like can be used.

Furthermore, in the transparent gas barrier film including the inorganic thin film layer, at least one or more printed layers, and one or more different plastic films and/or sheets of paper may be laminated between the inorganic thin film layer or the plastic film and the heat-sealable resin layer, or the outside thereof.

As a printing ink for forming the printed layer, an aqueous and solvent-based resin-containing printing ink can be preferably used. Examples of the resin used in the printing ink include an acrylic resin, a urethane-based resin, a polyester-based resin, a vinyl chloride-based resin, a vinyl acetate copolymer resin, and a mixture thereof. The printing ink may contain known additives such as an anti-static agent, a light blocking agent, an ultraviolet absorber, a plasticizer, a lubricant, a filler, a coloring agent, a stabilizer, a lubricant, a defoaming agent, a crosslinking agent, an anti-blocking agent, and an oxidation inhibitor. A printing method for providing the printing layer is not particularly limited, and known printing methods such as an offset printing method, a gravure printing method, and a screen printing method can be used. In order to dry the solvent after printing, known drying methods such as hot air drying, hot roll drying, and infrared drying can be used.

Meanwhile, as other plastic substrates and paper substrates, a sheet of paper, a polyester resin, a polyamide resin, and a biodegradable resin and the like are preferably used from the viewpoint of obtaining sufficient rigidity and strength of the laminated body. In order to produce a laminated body having excellent mechanical strength, a stretched film such as a biaxially stretched polyester film or a biaxially stretched nylon film is preferable.

In particular, when a transparent gas barrier film including an inorganic thin film layer is used as a packaging material, a nylon film is preferably laminated between the inorganic thin film layer and the heat-sealable resin layer in order to improve mechanical properties such as pinhole resistance and piercing strength. As the type of the nylon, nylon 6, nylon 66, and m-xyleneadipamide and the like are usually used. The thickness of the nylon film **is usually 10 to 30 $\mu$m, and preferably 15 to 25 $\mu$m. If the nylon film is thinner than 10 $\mu$m, the nylon film may be** short in strength. Meanwhile, if the nylon film is thicker **than 30 $\mu$m, the nylon film may be large in firmn**ess to be unsuitable for processing. The nylon film is preferably a biaxially stretched film having a stretch ratio of usually 2 times or more, and preferably about 2.5 to 4 times in each of the machine and transverse directions.

The transparent barrier film of the present invention also includes an aspect having each of the above-described layers other than the inorganic thin film layer.

EXAMPLES

Hereinafter, the present invention will be specifically described with reference to Examples, but the present invention is not limited to Examples.

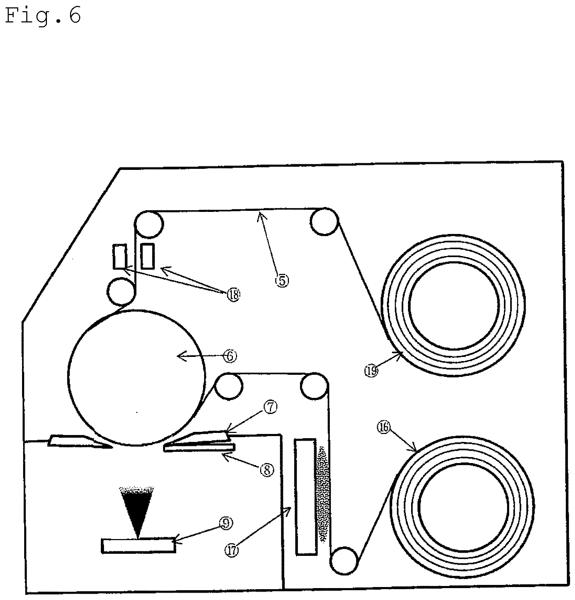

A transparent barrier film was formed by using a vapor-deposition apparatus having a vapor-deposition source in which boat-type resistance heating vapor-deposition sources (9) were arranged, and a roll-to-roll-type film traveling system shown in a schematic view described in Fig. 6.

An aluminum wire is fed into a boat made of BN composite.

An oxygen inlet (8) is installed in a coating window (7) .

A coating roll (6) was set at -5°C.

A substrate plastic film (5) is unwound from an unwinding roll (16). A vapor-deposition surface of the plastic film (5) is treated by a planar type plasma source (17), and the plastic film (5) is guided to the coating roll (6).

The plasma source (17) generated plasma in a state where an input power was set to 10 kw, and an argon gas of 400 sccm and an oxygen gas of 100 sccm were caused to flow.

The substrate plastic film (5) is guided to a coating window position for vapor-deposition by the coating roll (6) after the surface treatment.

The plastic film after vapor-deposition is caused to move to an optical film thickness meter (18) to measure a total light transmittance. After the measurement, the film is wound around a winding roll (19).

The evaluation methods are shown below.

(1) Total light transmittance

The total light transmittance during vapor-deposition was obtained by converting the value of the optical film thickness meter by using a sample measured by a turbidimeter (NDH 5000 manufactured by Nippon Denshoku Industries Co., Ltd.) according to JIS K7375.

The sample taken out after vapor-deposition was measured with the turbidimeter.

(2) Oxygen transmission rate (OTR)

An oxygen transmission rate (OTR) was measured under measurement conditions of a temperature of 23°C and a humidity of 65%RH using an oxygen transmission measuring apparatus (OXTRAN-2/20 manufactured by MOCON Inc., US) according to JIS K7126-2.

(3) Water vapor transmission rate (WVTR)

A water vapor transmission rate (WVTR) was measured under measurement conditions of a temperature of 40°C and a humidity of 90%RH using a water vapor transmission measuring apparatus (PERMATRAN-W3/31 manufactured by MOCON Inc., US) according to JIS K7129B.

(4) Acid resistance

A laminated film is formed by dry-laminating a linear low density polyethylene film (LLDPE: **L4102 40 um,** manufactured by Toyobo Co., Ltd.) on the formed transparent barrier film. For the dry lamination, an adhesive obtained by mixing TM569 and CAT-10L manufactured by Toyo-Morton, Ltd. was used.
The laminated film is cut into two A5 size films (148 mm × 210 mm). The two films are sealed at three sides in a state where the films L4012 are overlapped, to form a bag. A seal width is 10 mm.
The bag is filled with 100 ml of a dilution obtained by diluting vinegar (manufactured by Mizukan, grain vinegar) to 50% with water, and sealed. The bag is placed in a room at 40°C and stored for 1 week.
After 1 week, the contents are taken out, washed with water, and dried, followed by measuring the oxygen transmission rate.
The acid resistance is evaluated by the oxygen transmission rate.

(5) Content rates of terephthalic acid and isophthalic acid components contained in raw material polyester and polyester constituting film

A sample solution was prepared by dissolving a raw material polyester resin or a polyester film in a solvent in which chloroform D (manufactured by Euriso-Top Co., Ltd.) and trifluoroacetic acid D1 (manufactured by Euriso-Top Co., Ltd.) were mixed at 10:1 (volume ratio). Then, NMR of protons in the prepared sample solution was measured using an NMR apparatus (nuclear magnetic resonance analyzer: GEMINI-200 manufactured by Varian) under the measurement conditions of a temperature of 23°C and an integration number of 64. In the NMR measurement, the peak intensity of a predetermined proton was calculated, and the content rates (mol%) of the terephthalic acid component and the isophthalic acid component in 100 mol% of the acid components were calculated.

(6) Intrinsic viscosity (IV) of raw material resin and resin constituting film

A sample was vacuum-dried at 130°C all day and all night, and then pulverized or cut. 80 mg of the obtained sample was accurately weighed, and heat-dissolved at 80°C for 30 minutes in a mixed solution of phenol/tetrachloroethane=60/40 (volume ratio). The solution was heat-dissolved at 80°C, and then cooled to normal temperature. The mixed solvent prepared at the above ratio was added in a measuring flask to adjust the total volume to 20 ml, followed by performing measurement at 30°C (unit: dl/g). An Ostwald viscometer was used to measure the intrinsic viscosity.

(7) Thickness of plastic film

The thickness Tn (n=l to 200) (unit: um) of a film of 1 m in the machine direction and 1 m in the transverse direction was measured at every 5 mm and at 200 points by using PEACOCK dial gauge (manufactured by Ozaki Mfg. Co., Ltd.), and the average value thereof was taken as the thickness of the substrate film.

(8) Heat shrinkage rate of plastic film in machine and transverse directions

A film was sampled in 10 mm width and marked at every 200 mm with marked lines at room temperature (27°C), and the intervals (L0) between neighboring marked lines were measured. Thereafter, the plastic film was sandwiched between sheets of paper and treated in a hot air oven controlled to 150°C for 30 minutes, and then taken out. Thereafter, the intervals (L) between marked lines were measured and the heat shrinkage rate was calculated according to the following formula. Sampling was carried out in both the machine direction and the transverse direction for the measurement.

$$\text{Heat shrinkage rate } (\%) = \{(L0 - L)/L0\} \times 100$$

(9) Refractive index of plastic film in thickness direction

The refractive index (Nz) in the thickness direction was measured according to JIS K7142 using an Abbe's refractometer NAR-1T (manufactured by ATAGO Co., Ltd.). Sodium D ray was employed as a light source, a test piece having a refractive index of 1.74 was used, and methylene iodide was used as an intermediate liquid.

(10) Lamination strength of plastic film

The produced plastic film and a polyethylene film ("L4102" manufactured by Toyobo Co., Ltd.) having a thickness of 40 μm were laminated on the opposite side of the surface of the substrate film on which the inorganic thin film layer was laminated using an urethane type adhesive (TM569, CAT10L, and ethyl acetate at 33.6 : 4.0 : 62.4 (weight ratio) manufactured by Toyo-Morton, Ltd.) by a dry lamination method and aged at 40°C for 4 days to obtain a laminated body for lamination strength evaluation. Herein, the lamination conditions were a line velocity of 20 m/min, a drier temperature of 80°C, and an application amount after drying of 3 g/m$^2$. The laminated body was cut into a specimen having a size of 15 mm in width and 200 mm in length, and the peel strength (N/15 mm) at the interface between the polyolefin resin layer and the opposite side surface of the inorganic thin film layer-laminated surface of the substrate film was measured under the conditions of a temperature of 23°C and a relative humidity of 65% by using "Tensilon UMT-II-500" manufactured by Toyo Baldwin. The tensile speed was 20 cm/min and the peel angle was 180 degrees.

(11) Appearance evaluation of plastic film after lamination peeling

The sheet after the peeling of (10) was treated with a neocarmine solution at 50°C for 30 minutes, and the area ratio of a portion not dyed pink was determined to evaluate the appearance of the plastic film after lamination peeling. The good level means that there are no voids of the adhesive in the surface after peeling; the average level means that there are voids of the adhesive in 10% or less of the total peeled surface area; and the poor level means that there are voids of the adhesive in more than 10% of the total peeled surface area.

(12) Thickness unevenness of plastic film

The thickness Tn (n=1 to 200) (unit: μm) of a film of 1 m in the machine direction and 1 m in the transverse direction was measured at every 5 mm and at 200 points by using PEACOCK dial gauge (manufactured by Ozaki Mfg. Co., Ltd.), and the maximum thickness was taken as Tmax, the minimum thickness was taken as Tmin, and the average thickness was taken as Tave. The thickness unevenness was calculated according to the following formula (4).

```
Thickness unevenness = {(Tmax - Tmin)/Tave} × 100

(%) ... Formula (4)
```

(13) Film thickness of inorganic thin film layer

The film thickness of the aluminum oxide layer was determined by a fluorescent X-ray apparatus (Supermini 200 manufactured by Rigaku Corporation). A calibration curve was prepared by identifying the aluminum adhesion amount of a sample prepared in advance by inductively coupled plasma emission spectroscopy, determining the film thickness, and determining the fluorescent X-ray intensity of the sample.

Example 1

Preparation of polyester resin obtained by recycling PET bottles

A recycled polyester raw material was obtained by washing PET bottles for beverages to remove foreign matters such as the remaining beverage, thereafter melting flakes obtained by pulverizing the PET bottles by an extruder, further changing the filter with a filter having a smaller mesh size, then separating the finer foreign matters by filtration twice, and then separating the finer foreign matters by third filtration using a filter with the smallest mesh size of 50 μm. The obtained resin had a composition of terephthalic acid/isophthalic acid//ethylene glycol=97.0/3.0//100 (mol%), and the intrinsic viscosity of the resin was 0.70 d1/g. The resin was taken as a polyester A.

Production of plastic film

A plastic film was produced using a polyethylene terephthalate resin of terephthalic acid//ethylene glycol=100//100 (mol%) as a polyester B having an intrinsic viscosity of 0.62 d1/g, and a master batch containing, as a polyester C, the polyester B and 0.3% of amorphous silica having an average particle diameter of 1.5μm. The respective raw materials were dried at 125°C under a reduced pressure of 33 Pa for 8 hours. These polyesters were mixed in a manner that A/B/C became 80/10/10 (weight ratio) and charged into a uniaxial extruder. The temperature was set so as to keep the resin temperature at 280°C from the extruder to a melt line, a filter, and a T-die. Here, the temperature was set so as to adjust the resin temperature to 305°C for 45 seconds from the starting point of a compaction part of a screw of the extruder and thereafter to 280°C again.

The melt extruded from the T-die was attached closely to a cooling roll to obtain an un-stretched sheet. Then, the un-stretched sheet was stretched (MD1) 1.41 times in the machine direction with rolls heated to 118°C and having different circumferential speeds, and further stretched (MD2) 2.92 times in the machine direction with rolls heated to 128°C and having different circumferential speeds. The sheet stretched in the machine direction was led to a tenter, preheated at 121°C, and thereafter stretched 4.3 times in the machine direction at 131°C. Then, for heat fixation, the sheet was subjected to treatment at 180°C without relaxation (0%) for 2.5 seconds (TS1), thereafter to treatment at 231°C with 5% of relaxation for 3.0 seconds (TS2), and further to treatment at 222°C without relaxation for 2.5 seconds (TS3). Then, the sheet was cooled in the same tenter at 120°C for 6.0 seconds and finally wound with a winder to obtain a biaxially stretched polyester film (plastic film) having a thickness of 12 um.

The plastic film contains 80% of the polyester A obtained by recycling PET bottles.

A content rate of an isophthalic acid component relative to total dicarboxylic acid components in a total polyester resin constituting the plastic film is 2.4 mol%. The intrinsic viscosity of the resin constituting the plastic film is 0.64 dl/g.

The plastic film has a heat shrinkage rate of 0.8% in a machine direction and 0.5% in a transverse direction at 150°C.

The plastic film has thickness unevenness of 7.6% in a machine direction and thickness unevenness of 6.4% in a transverse direction.

Lamination strength when the polyethylene film was laminated was 6.1 N/15 mm, and the appearance of the peeled surface was also at the level of good.

The total light transmittance of the plastic film is 84%.

This plastic film was set in a vapor-deposition apparatus. First, aluminum was vapor-deposited without adding oxygen to achieve a total light transmittance of 18%. The total light transmittance was stabilized, and the oxygen was then introduced to control the total light transmittance to 64%. The amount of the oxygen introduced was 12509 sccm. A pressure in a vapor-deposition chamber after the introduction of the oxygen was $1.4 \times 10^{-3}$ Pa. Table 1 shows the conditions of Example 1.

This transparent barrier film was rewound at a speed of 333 m/min using a slitter. From the diameter of the rewound rolled plastic film, the amount of air entrained was estimated to be contained at a thickness of about 0.4 μm in the plastic film.

The rewound transparent barrier film was stored in a room at 23°C for 3 weeks, and the total light transmittance was then measured with a turbidimeter to calculate an absorption coefficient. The results are shown in Table 2. The OTR and WVTR obtained by measuring the laminated film obtained by bonding the LLDPE to the transparent barrier film are shown in Table 2. Furthermore, the results of the acid resistance test are shown in Table 2.

Example 2

A sample was prepared in the same manner as in Example 1 except that the polyesters were mixed in a manner that A/B/C became 60/30/10 (weight ratio) in Example 1. The results of evaluating Example 2 are shown in Table 2. The content rate of an isophthalic acid component relative to total dicarboxylic acid components in a total polyester resin constituting a plastic film is 1.8 mol%. The intrinsic viscosity of the resin constituting the plastic film is 0.63 dl/g.

The plastic film has a heat shrinkage rate of 0.9% in a machine direction and 0.5% in a transverse direction at 150°C.

The plastic film has thickness unevenness of 7.9% in a machine direction and thickness unevenness of 6.4% in a transverse direction.

Lamination strength when the polyethylene film was laminated was 6.2 N/15 mm, and the appearance of the peeled surface was also at the level of good.

The total light transmittance of the plastic film is 83%.

Example 3

A sample was prepared in the same manner as in Example 1 except that vapor-deposition was performed under the conditions shown in Table 1 in Example 1. The results of evaluating Example 2 are shown in Table 2. A content rate of an isophthalic acid component relative to total dicarboxylic acid components in a total polyester resin constituting the plastic film is 2.4 mol%. The intrinsic viscosity of the resin constituting the plastic film is 0.64 dl/g.

The plastic film has a heat shrinkage rate of 0.8% in a machine direction and 0.5% in a transverse direction at 150°C.

The plastic film has thickness unevenness of 7.6% in a machine direction and thickness unevenness of 6.4% in a transverse direction.

Lamination strength when the polyethylene film was laminated was 6.1 N/15 mm, and the appearance of the peeled surface was also at the level of good.

The total light transmittance of the plastic film is 84%.

Comparative Example 1

A sample was prepared in the same manner as in Example 1 except that vapor-deposition was performed under the conditions shown in Table 1.

The results of evaluating the sample of Comparative Example 1 are shown in Table 2. A content rate of an isophthalic acid component relative to total dicarboxylic acid components in a total polyester resin constituting the plastic film is 2.4 mol%. The intrinsic viscosity of the resin constituting the plastic film is 0.64 dl/g.

The plastic film has a heat shrinkage rate of 0.8% in a machine direction and 0.5% in a transverse direction at 150°C.

The plastic film has thickness unevenness of 7.6% in a machine direction and thickness unevenness of 6.4% in a transverse direction.

Lamination strength when the polyethylene film was laminated was 6.1 N/15 mm, and the appearance of the peeled surface was also at the level of good.

The total light transmittance of the plastic film is 84%.

[Table 1]

| | Total light transmittance % | | | Vapor-deposition conditions | | |
|---|---|---|---|---|---|---|
| | Substrate plastic film | Aluminum | Aluminum oxide | Amount of oxygen introduced | Pressure | Film traveling speed |
| | | | | sccm | mPa | m/min |
| Example 1 | 84 | 18 | 64 | 12509 | 1.4 | 333 |
| Example 2 | 83 | 18 | 64 | 12510 | 1.4 | 333 |
| Example 3 | 84 | 18 | 64 | 12509 | 1.5 | 400 |
| Comparative Example 1 | 84 | 18 | 58 | 11452 | 1.4 | 333 |

[Table 2]

| | Film thickness | Absorption coefficient $nm^{-1}$ | | WVTR | OTR $mL/m^2 \cdot d \cdot Mpa$ | |
|---|---|---|---|---|---|---|
| | nm | Immediately after vapor-deposition | After 3 weeks | $g/m^2$ day | Untreated | After acid resistance test |
| Example 1 | 10 | 0.027 | 0.000 | 0.6 | 13 | 39 |
| Example 2 | 10 | 0.027 | 0.000 | 0.6 | 13 | 39 |
| Example 3 | 8 | 0.027 | 0.000 | 0.6 | 13 | 40 |

(continued)

| | Film thickness | Absorption coefficient nm$^{-1}$ | | WVTR | OTR mL/m$^2$·d·Mpa | |
|---|---|---|---|---|---|---|
| | nm | Immediately after vapor-deposition | After 3 weeks | g/m$^2$ day | Untreated | After acid resistance test |
| Comparative Example 1 | 11 | 0.033 | 0.004 | 0.6 | 10 | 842 |

In Comparative Example 1 with respect to Examples 1 to 3, the absorption coefficient immediately after vapor-deposition was higher than 0.03 nm$^{-1}$, whereby the value of the OTR after the acid resistance test was high, which caused impaired barrier properties.

INDUSTRIAL APPLICABILITY

The present invention makes it possible to provide a transparent barrier film that is environmentally friendly through reuse of PET bottles, and includes, as a barrier layer, an aluminum oxide layer capable of being produced at a low cost to have excellent acid resistance and be capable of packaging a wide range of contents.

DESCRIPTION OF REFERENCE SIGNS

1 Transmittance wavelength characteristics of substrate plastic film (12 $\mu$m-thick PET film)
2 Transmittance wavelength characteristics of transparent gas barrier film on which aluminum oxide layer is laminated
3 Spectral power wavelength characteristics of D65 light source
4 y color-matching function
5 Plastic film
6 Coating roll
7 Coating window
8 Oxygen inlet
9 Vapor-deposition source (Resistance heating boat)
10 Screw
11 Flight
12 Barrel
13 Supply part
14 Compaction part
15 Measurement part
16 Uunwinding roll
17 Plasma source
18 Optical film thickness meter
19 Winding roll

**Claims**

1. A transparent gas barrier film comprising an aluminum oxide layer mainly composed of aluminum oxide on at least one surface of a substrate polyester film, wherein an absorption coefficient immediately after vapor-deposition of the aluminum oxide layer is less than 0.03 nm$^{-1}$, a vapor-deposition film thickness of the aluminum oxide layer is 6 nm or more and 10 nm or less, the substrate polyester film is a biaxially stretched polyester film containing 50% by weight or more of a polyester resin obtained by recycling PET bottles, and the following requirements are satisfied:

   (1) a content rate of an isophthalic acid component relative to total dicarboxylic acid components in a total polyester resin constituting the substrate polyester film is 0.5 mol% or more and 5.0 mol% or less;
   (2) an intrinsic viscosity of the resin constituting the substrate polyester film is 0.58 dl/g or more and 0.70 dl/g or less;

(3) the substrate polyester film has a heat shrinkage rate of 0.1% or more and 1.5% or less at 150°C in a machine direction and a transverse direction;

(4) when a polyolefin film is laminated on an opposite side of the surface of the substrate polyester film on which the aluminum oxide layer is laminated, lamination strength between the polyolefin film and the substrate polyester film is 4.0 N/15 mm or more and 20.0 N/15 mm or less; and

(5) a thickness Tn (n=l to 200) (unit: $\mu$m) of a film of 1 m in the machine direction and 1 m in the transverse direction is measured at every 5 mm and at 200 points; and thickness unevenness determined by the following formula when a maximum thickness at this time is Tmax, a minimum thickness is Tmin, and an average thickness is Tave is 16% or less in each of the machine direction and the transverse direction:

$$\texttt{Thickness unevenness = \{(Tmax - Tmin)/Tave\} × 100 (\%).}$$

2. The transparent gas barrier film according to claim 1, wherein the absorption coefficient immediately after vapor-deposition is 0.02 nm$^{-1}$ or more.

3. The transparent gas barrier film according to claim 1 or 2, wherein the absorption coefficient is finally 0.002 nm$^{-1}$ or less.

Fig.1

Fig.2

Fig.3

Fig.4

Fig.5

Fig.6

## INTERNATIONAL SEARCH REPORT

International application No.

**PCT/JP2021/043001**

### A. CLASSIFICATION OF SUBJECT MATTER

*B32B 9/00*(2006.01)i; *B32B 27/36*(2006.01)i; *C23C 14/08*(2006.01)i
FI:  B32B9/00 A; B32B27/36; C23C14/08 A

According to International Patent Classification (IPC) or to both national classification and IPC

### B. FIELDS SEARCHED

Minimum documentation searched (classification system followed by classification symbols)

B32B9/00; B32B27/36; C23C14/08

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2015/146496 A1 (TOYOBO CO., LTD.) 01 October 2015 (2015-10-01) entire text, all drawings | 1-3 |
| A | JP 2017-177343 A (TORAY ADVANCED FILM CO., LTD.) 05 October 2017 (2017-10-05) entire text, all drawings | 1-3 |
| A | JP 2000-25183 A (DAINIPPON PRINTING CO., LTD.) 25 January 2000 (2000-01-25) entire text, all drawings | 1-3 |
| A | WO 2019/031263 A1 (TOYOBO CO., LTD.) 14 February 2019 (2019-02-14) entire text | 1-3 |
| A | JP 2005-178100 A (TORAY ADVANCED FILM CO., LTD.) 07 July 2005 (2005-07-07) entire text | 1-3 |
| P, A | WO 2020/241621 A1 (TOYOBO CO., LTD.) 03 December 2020 (2020-12-03) entire text, all drawings | 1-3 |

☐ Further documents are listed in the continuation of Box C.   ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **05 January 2022** | **18 January 2022** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 **Japan** | |
| | Telephone No. |

Form PCT/ISA/210 (second sheet) (January 2015)

INTERNATIONAL SEARCH REPORT
Information on patent family members

International application No.

**PCT/JP2021/043001**

| Patent document cited in search report | | | Publication date (day/month/year) | Patent family member(s) | | | Publication date (day/month/year) |
|---|---|---|---|---|---|---|---|
| WO | 2015/146496 | A1 | 01 October 2015 | TW 201544319 A entire text, all drawings | | | |
| JP | 2017-177343 | A | 05 October 2017 | (Family: none) | | | |
| JP | 2000-25183 | A | 25 January 2000 | (Family: none) | | | |
| WO | 2019/031263 | A1 | 14 February 2019 | US 2020/0224304 A1 entire text EP 3666519 A1 CN 111032335 A KR 10-2020-0040795 A CA 3072406 A TW 201922881 A | | | |
| JP | 2005-178100 | A | 07 July 2005 | (Family: none) | | | |
| WO | 2020/241621 | A1 | 03 December 2020 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014050844 A
- JP 2929609 B
- JP 2638797 B
- WO 2015146496 A